# EUROPÄISCHE PATENTANMELDUNG

(11) **EP 3 016 254 A2**
(43) Veröffentlichungstag der Anmeldung: **04.05.2016**
(21) Anmeldenummer: 15003047.6
(22) Anmeldetag: 24.10.2015
(51) Int. Cl.: H02K 11/33, H05K 1/00, H02K 5/20, H02K 9/22, H05K 7/20, H02K 9/19

(54) **KÜHLUNG EINER ELEKTRISCHEN ANTRIEBSEINRICHTUNG**

(30) Priorität: 03.11.2014 DE 102014016171
(71) Anmelder: AUDI AG, 85045 Ingolstadt (DE)
(72) Erfinder: Rusch, Josef, DE - 85098 Großmehring (DE)

(57) **Zusammenfassung**

Die Erfindung betrifft eine elektrische Antriebseinrichtung (1), mit einem Elektromotor (2) und einer Leistungselektronikvorrichtung (10) zur Ansteuerung des Elektromotors (2), wobei ein Motorgehäuse (3) des Elektromotors (2) wenigstens einen Kühlmittelkanal (6) zur Kühlung des Elektromotors (2) aufweist. Dabei ist vorgesehen, dass ein Elektronikgehäuse (11) der Leistungselektronik (10) eine Anschlussfläche (12) aufweist, die mit einer Gegenanschlussfläche (13) des Motorgehäuses (3) verbunden ist, wobei die Leistungselektronikvorrichtung (10) kühlmittelkanalfrei ausgebildet und wärmeübertragend mit dem Motorgehäuse (3) verbunden ist.

## Beschreibung

Die Erfindung betrifft eine elektrische Antriebseinrichtung, mit einem Elektromotor und einer Leistungselektronikvorrichtung zur Ansteuerung des Elektromotors, wobei ein Motorgehäuse des Elektromotors wenigstens einen Kühlmittelkanal zur Kühlung des Elektromotors aufweist.

Die elektrische Antriebseinrichtung dient beispielsweise dem Antreiben eines Kraftfahrzeugs, insoweit also dem Bereitstellen eines auf das Antreiben des Kraftfahrzeugs gerichteten Drehmoments. Die elektrische Antriebseinrichtung verfügt zu diesem Zweck über den Elektromotor, wobei der Elektromotor beziehungsweise dessen Antriebswelle beispielsweise mit einer Eingangswelle eines Schaltgetriebes des Kraftfahrzeugs wirkverbunden ist. Der Elektromotor wird mittels der Leistungselektronikvorrichtung angesteuert. Die Leistungselektronikvorrichtung weist zu diesem Zweck wenigstens ein Leistungselektronikbauteil, beispielsweise einen Leistungstransistor oder einen Leistungs-MOSFET, auf. Vorzugsweise umfasst die Leistungselektronikvorrichtung einen Wechselrichter, um Gleichstrom, der von einem Bordnetz des Kraftfahrzeugs zur Verfügung gestellt wird, in Wechselstrom zum Antreiben des Elektromotors umzusetzen. Der Elektromotor ist insoweit bevorzugt als Wechselstrommotor oder als Drehstrommotor ausgebildet.

Weil die elektrische Antriebseinrichtung üblicherweise eine recht hohe Maximalleistung aufweist, ist eine Kühlung des Elektromotors notwendig. Zu diesem Zweck ist der wenigstens eine Kühlmittelkanal in dem Motorgehäuse des Elektromotors ausgebildet. Der Kühlmittelkanal ist beispielsweise Bestandteil eines Kühlkreislaufs der elektrischen Antriebseinrichtung. In dem Kühlmittelkanal kann ein Kühlmittel umgewälzt werden, beispielsweise mithilfe einer Kühlmittelpumpe. Mithilfe des Kühlmittels wird die in dem Elektromotor anfallende Wärme zuverlässig abgeführt.

Es ist nun Aufgabe der Erfindung, eine elektrische Antriebseinrichtung vorzuschlagen, welche gegenüber dem bekannten Stand der Technik Vorteile aufweist, insbesondere bei weiterhin hoher Leistung einfach und kostengünstig herstellbar ist.

Dies wird erfindungsgemäß mit einer elektrischen Antriebseinrichtung mit den Merkmalen des Anspruchs 1 erreicht. Dabei ist vorgesehen, dass ein Elektronikgehäuse der Leistungselektronik eine Anschlussfläche aufweist, die mit einer Gegenanschlussfläche des Motorgehäuses verbunden ist, wobei die Leistungselektronikvorrichtung kühlkanalfrei ausgebildet und wärmeübertragend mit dem Motorgehäuse verbunden ist. Wie bereits vorstehend erläutert, kann in dem Elektromotor aufgrund seiner hohen Maximalleistung eine hohe Wärmemenge anfallen. Dies gilt analog für die Leistungselektronikvorrichtung, welche zur Ansteuerung des Elektromotors herangezogen wird.

Aus diesem Grund ist neben der Kühlung des Elektromotors auch eine Kühlung der Leistungselektronikvorrichtung notwendig. Diese kann beispielsweise erzielt werden, indem auch in der Leistungselektronikvorrichtung, insbesondere in dem Elektronikgehäuse, wenigstens ein Kühlmittelkanal vorgesehen ist. Dieser kann zur Kühlung der Leistungselektronikvorrichtung analog zu dem Kühlmittelkanal des Motorgehäuses von Kühlmittel durchströmt werden. Eine derartige Ausgestaltung der elektrischen Antriebseinrichtung ist jedoch vergleichsweise aufwändig und mithin kostenträchtig. Zudem wird ein vergleichsweise großer Bauraum benötigt, um den Kühlmittelkanal in der Leistungselektronikvorrichtung vorsehen zu können.

Aus diesem Grund soll nun die Leistungselektronikvorrichtung beziehungsweise das Elektronikgehäuse kühlmittelkanalfrei ausgebildet sein, also keinen eigenen Kühlkanal aufweisen. Stattdessen ist es vorgesehen, dass die Leistungselektronikvorrichtung wärmeübertragend mit dem Motorgehäuse verbunden ist. Auf diese Art und Weise kann in der Leistungselektronikvorrichtung anfallende Wärme von dieser an das Motorgehäuse abgegeben werden, von wo aus es nachfolgend ohne weiteres abgeführt werden kann, insbesondere mittels dem den Kühlmittelkanal durchströmenden Kühlmittel.

Zur Herstellung der Wärmeübertragungsverbindung zwischen der Leistungselektronikvorrichtung und dem Motorgehäuse weist das Elektronikgehäuse die Anschlussfläche auf, während der Elektromotor beziehungsweise dessen Motorgehäuse über die Gegenanschlussfläche verfügt. Besonders bevorzug sind die Anschlussfläche sowie die Gegenanschlussfläche plan ausgebildet, sind also abgesehen von einer jeder Oberfläche inhärenten Rauigkeit im Wesentlichen flach. Die Anschlussfläche liegt nun vorzugsweise flächig beziehungsweise plan an der Gegenanschlussfläche des Motorgehäuses an oder ist zumindest wärmeübertragend mit ihr verbunden. Somit ist eine vergleichsweise große Kontaktfläche geschaffen, über welche die Wärme von der Leistungselektronikvorrichtung auf das Motorgehäuse übergehen kann. Entsprechend kann die Leistungselektronikvorrichtung kleiner und kostengünstiger gebaut werden, weil in ihr kein eigener Kühlmittelkanal vorgesehen sein muss. Entsprechend entfällt auch ein Abdichten dieses Kühlmittelkanals gegenüber der Leistungselektronikvorrichtung.

In einer weiteren Ausgestaltung der Erfindung ist vorgesehen, dass zwischen der Anschlussfläche und der Gegenanschlussfläche wenigstens bereichsweise, insbesondere vollflächig, ein Wärmeleitelement angeordnet ist. Das Wärmeleitelement dient einer Verbesserung der Wärmeübertragung von der Leistungselektronikvorrichtung auf das Motorgehäuse. Insoweit besteht das Wärmeleitelement aus einem Material, welches einen hohen Wärmeleitkoeffizienten aufweist oder zumindest die Effizienz der Wärmeübertragungsverbindung zwischen der Leistungselektronikvorrichtung und dem Motorgehäuse verbessert. Das Wärmeleitelement liegt zumindest bereichsweise zwischen der Anschlussfläche und der Gegenanschlussfläche vor. Besonders bevorzugt bedeckt es jedoch zumindest die Anschlussfläche vollflächig, besonders bevorzugt ist dies auch für die Gegenanschlussfläche der Fall.

In einer weiteren Ausgestaltung der Erfindung ist vorgesehen, dass das Wärmeleitelement als Wärmeleitfolie oder Wärmeleitklebstoff ausgebildet ist. Die Wärmeleitfolie besteht beispielsweise aus einem Elastomer, insbesondere einem Silikonelastomer. Das Elastomer kann mittels eines Gewebes, beispielsweise eines Glasgewebes, verstärkt sein. Das Material der Wärmeleitfolie kann zudem wenigstens eine Beimengung aufweisen, welche die Wärmeleitfähigkeit der Wärmeleitfolie verbessert, insbesondere Aluminium, Kupfer, Graphit und/oder Silber. Alternativ kann das Wärmeleitelement als Wärmeleitklebstoff ausgebildet sein. Das bedeutet, dass das Wärmeleitelement nicht lediglich eine Wärmeübertragungsfunktion, sondern zusätzlich eine Befestigungsfunktion aufweist. Mithilfe des Wärmeleitklebstoffs kann insoweit die Leistungselektronikvorrichtung an dem Motorgehäuse des Elektromotors befestigt sein. Der Wärmeleitklebstoff kann grundsätzlich aus denselben Materialien bestehen wie die Wärmeleitfolie.

In einer Weiterbildung der Erfindung ist vorgesehen, dass das Elektronikgehäuse mittels wenigstens einer Schraubbefestigung und/oder stoffschlüssig mittels des Wärmeleitelements an dem Motorgehäuse befestigt ist. Grundsätzlich kann das Elektronikgehäuse beliebig an dem Motorgehäuse befestigt sein, sofern die Anschlussfläche mit der Gegenanschlussfläche verbunden ist, insbesondere flächig an der Gegenanschlussfläche anliegt. Bevorzugt ist jedoch eine formschlüssige und/oder kraftschlüssige Befestigung, welche beispielsweise mithilfe der Schraubbefestigung realisiert ist. Zusätzlich oder alternativ kann das Elektronikgehäuse mithilfe des Wärmeleitelements an dem Motorgehäuse befestigt sein. Zu diesem Zweck ist das Wärmeleitelement beispielsweise als selbstklebende Wärmeleitfolie oder als Wärmeleitklebstoff ausgebildet.

In einer weiteren Ausgestaltung der Erfindung ist vorgesehen, dass wenigstens ein elektrischer Anschluss des Elektromotors das Wärmeleitelement durchgreift. Im Bereich der Anschlussfläche und der Gegenanschlussfläche liegen die Leistungselektronikvorrichtung und das Motorgehäuse aneinander an. Insoweit stellt der Weg durch das Wärmeleitelement die kürzeste Verbindung zwischen der Leistungselektronikvorrichtung und dem Elektromotor dar. Entsprechend durchgreift der elektrische Anschluss, welcher beispielsweise in Form einer Leitung oder einer Leiterbahn vorliegt, das Wärmeleitelement. Zu diesem Zweck ist beispielsweise eine Öffnung in dem Wärmeleitelement vorgesehen, welche randgeschlossen vorliegt und mithin Seitenflächen des Wärmeleitelements nicht durchgreift. Bevorzugt sind mehrere elektrische Anschlüsse vorgesehen, insbesondere ein elektrischer Anschluss für jede Phase des Elektromotors.

In einer besonders bevorzugten Ausgestaltung der Erfindung ist vorgesehen, dass die Gegenanschlussfläche an einem Motorflansch des Motorgehäuses vorliegt. Der Motorflansch des Motorgehäuses dient der sicheren Befestigung der Leistungselektronikvorrichtung an dem Elektromotor. Der Motorflansch erstreckt sich insoweit ausgehend von dem Motorgehäuse in Richtung der Leistungselektronikvorrichtung. Während weitere Bereiche des Motorgehäuses weitgehend rund sein können, ist der Motorflansch vorzugsweise rechteckig ausgebildet. Insbesondere wird durch die rechteckige Ausgestaltung des Motorflanschs die plane Gegenanschlussfläche des Motorgehäuses ausgebildet.

In einer weiteren Ausgestaltung der Erfindung ist vorgesehen, dass der Kühlmittelkanal einen Abstand von der Gegenanschlussfläche aufweist, die bezogen auf einen Durchmesser des Kühlmittelkanals kleiner ist als 1, als 0,75, als 0,5 oder als 0,25. Um eine ausreichende Kühlung der Leistungselektronikvorrichtung mithilfe des in dem Kühlmittelkanal vorliegenden Kühlmittels zu erzielen, ist es notwendig, dass der Kühlmittelkanal im Bereich der Leistungselektronikvorrichtung und mithin im Bereich der Gegenanschlussfläche vorliegt. Vorzugsweise erstreckt sich der Kühlmittelkanal dabei durch den Motorflansch hindurch beziehungsweise in diesen hinein. An wenigstens einem Punkt weist der Kühlmittelkanal den genannten Abstand auf. Dieser ist dabei auf den Durchmesser des Kühlmittelkanals bezogen. Das bedeutet, dass der Abstand des Kühlmittelkanals von der Gegenanschlussfläche höchstens so groß ist wie sein Durchmesser, bevorzugt jedoch kleiner. Besonders bevorzugt verläuft der Kühlmittelkanal wenigstens bereichsweise parallel zu der Gegenanschlussfläche. Insbesondere weist er dabei den genannten Abstand oder einen kleineren Abstand auf.

In einer weiteren bevorzugten Ausgestaltung der Erfindung ist vorgesehen, dass der Kühlmittelkanal einen Rotor des Elektromotors in Umfangsrichtung bezüglich einer Drehachse des Rotors wenigstens bereichsweise, insbesondere vollständig, umgreift. Der Elektromotor verfügt üblicherweise über einen Stator und den Rotor, wobei letzterer mit der Antriebswelle des Elektromotors wirkverbunden ist, insbesondere starr und/oder permanent. Der Rotor weist die Drehachse auf, um welche er sich während eines Betriebs des Elektromotors dreht. Der Kühlmittelkanal umgreift nun den Rotor und/oder den Stator des Elektromotors in Umfangsrichtung bezüglich der Drehachse wenigstens teilweise. Besonders bevorzugt umgreift er den Rotor beziehungsweise den Stator in Umfangsrichtung jedoch vollständig, sodass eine gleichmäßige Kühlung des Elektromotors realisiert ist.

Schließlich ist in einer weiteren Ausgestaltung der Erfindung vorgesehen, dass die Anschlussfläche einer Seitenfläche des Elektronikgehäuses entspricht. Insbesondere entspricht die Anschlussfläche der gesamten Seitenfläche des Elektronikgehäuses. Dabei ist das Elektronikgehäuse im Wesentlichen quaderförmig, also im Querschnitt gesehen rechteckig. Bei einer derartigen Ausgestaltung des Elektronikgehäuses wird eine sehr große effektive Fläche realisiert, welche in Form der Anschlussfläche für eine Wärmeübertragung von der Leistungselektronikvorrichtung auf das Motorgehäuse zur Verfügung steht.

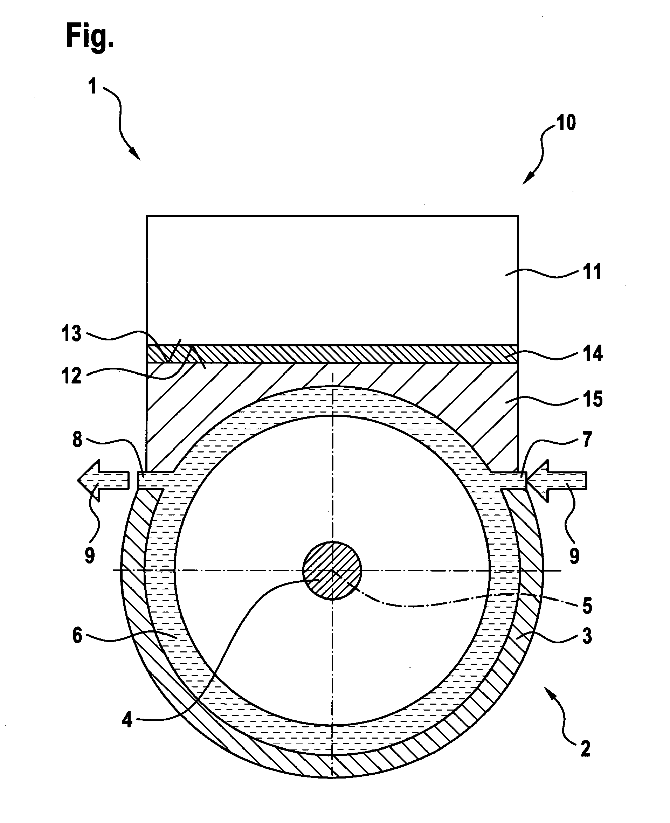

Die Erfindung wird nachfolgend anhand der in der Zeichnung dargestellten Ausführungsbeispiele näher erläutert, ohne dass eine Beschränkung der Erfindung erfolgt. Dabei zeigt die einzige
- Figur: eine schematische Querschnittsdarstellung einer elektrischen Antriebseinrichtung, insbesondere für ein Kraftfahrzeug.

Die Figur zeigt eine schematische Querschnittsdarstellung einer elektrischen Antriebseinrichtung 1, welche beispielsweise zum Antreiben eines Kraftfahrzeugs dient. Die Antriebseinrichtung 1 verfügt über einen Elektromotor 2, der ein Motorgehäuse 3 aufweist. In dem Motorgehäuse 3 ist ein hier nicht dargestellter Rotor des Elektromotors 2 angeordnet, welcher mit einer Antriebswelle des Elektromotors 2 wirkverbunden ist, vorzugsweise starr und/oder permanent. Die Antriebswelle 4 und mithin der Rotor weisen eine gemeinsame Drehachse 5 auf. In dem Motorgehäuse 3 ist wenigstens ein Kühlmittelkanal 6 vorgesehen, dem durch einen Kühlmittelanschluss 7 Kühlmittel zuführbar und über einen Kühlmittelanschluss 8 entnehmbar ist. Dies ist durch die Pfeile 9 angedeutet. Der Kühlmittelkanal 6 umgreift vorzugsweise den Rotor des Elektromotors 2 in Umfangsrichtung bezüglich der Drehachse 5 vollständig, wie dies hier dargestellt ist.

Neben dem Elektromotor 2 weist die Antriebseinrichtung 1 eine Leistungselektronikvorrichtung 10 auf, welche über ein Elektronikgehäuse 11 sowie über wenigstens ein darin angeordnetes Leistungselektronikelement verfügt. Es ist nun vorgesehen, dass das Elektronikgehäuse 11 eine Anschlussfläche 12 aufweist, die flächig an einer Gegenanschlussfläche 13 des Motorgehäuses 3 anliegt. Zumindest steht jedoch die Anschlussfläche 12 mit der Gegenanschlussfläche 13 in Wärmeübertragungsverbindung beziehungsweise ist mit ihr verbunden. Zu diesem Zweck liegt die Anschlussfläche 12 entweder unmittelbar an der Gegenanschlussfläche 13 an. Alternativ kann zwischen ihnen ein Wärmeleitelement 14 angeordnet sein. Das Wärmeleitelement 14 ist in der hier vorliegenden Ausführungsform bevorzugt als Wärmeleitfolie ausgestaltet. Die Anschlussfläche 12 entspricht vorzugsweise einer Seitenfläche des Elektronikgehäuses 11, welches besonders bevorzugt quaderförmig ausgestaltet ist. Beispielsweise entspricht dabei die Anschlussfläche 12 der größten Seitenfläche des Elektronikgehäuses 11.

Die Gegenanschlussfläche 13 des Motorgehäuses 3 liegt an einem Motorflansch 15 vor, welcher beispielsweise dieselben Außenabmessungen aufweist wie das Elektronikgehäuse 11. Entsprechend fluchtet das Elektronikgehäuse 11 nach seiner Montage an dem Elektromotor 2 mit dem Motorflansch 15. Das Elektronikgehäuse 11 ist kühlmittelkanalfrei ausgebildet, sodass also der Leistungselektronikvorrichtung 10 kein Kühlmittel zugeführt werden muss. Vielmehr ist über die Verbindung zwischen der Anschlussfläche 12 mit der Gegenanschlussfläche 13 eine Wärmeübertragungsverbindung zwischen der Leistungselektronikvorrichtung 10 und dem Motorgehäuse 3 realisiert. Entsprechend kann von der Leistungselektronikvorrichtung 10 erzeugte Wärme mittels des Kühlmittelkanals 6 beziehungsweise des darin strömenden Kühlmittels abgeführt werden. Dies ermöglicht eine äußerst kompakte und kostensparende Ausgestaltung der Antriebseinrichtung 1.

## Patentansprüche

1. Elektrische Antriebseinrichtung (1), mit einem Elektromotor (2) und einer Leistungselektronikvorrichtung (10) zur Ansteuerung des Elektromotors (2), wobei ein Motorgehäuse (3) des Elektromotors (2) wenigstens einen Kühlmittelkanal (6) zur Kühlung des Elektromotors (2) aufweist, **dadurch gekennzeichnet, dass** ein Elektronikgehäuse (11) der Leistungselektronik (10) eine Anschlussfläche (12) aufweist, die mit einer Gegenanschlussfläche (13) des Motorgehäuses (3) verbunden ist, wobei die Leistungselektronikvorrichtung (10) kühlmittelkanalfrei ausgebildet und wärmeübertragend mit dem Motorgehäuse (3) verbunden ist.

2. Elektrische Antriebseinrichtung nach Anspruch 1, **dadurch gekennzeichnet, dass** zwischen der Anschlussfläche (12) und der Gegenanschlussfläche (13) wenigstens bereichsweise, insbesondere vollflächig, ein Wärmeleitelement (14) angeordnet ist.

3. Elektrische Antriebseinrichtung nach einem der vorhergehenden Ansprüche, **dadurch gekennzeichnet, dass** das Wärmeleitelement (14) als Wärmeleitfolie oder Wärmeleitklebstoff ausgebildet ist.

4. Elektrische Antriebseinrichtung nach einem der vorhergehenden Ansprüche, **dadurch gekennzeichnet, dass** das Elektronikgehäuse (11) mittels wenigstens einer Schraubbefestigung und/oder stoffschlüssig mittels des Wärmeleitelements (14) an dem Motorgehäuse (3) befestigt ist.

5. Elektrische Antriebseinrichtung nach einem der vorhergehenden Ansprüche, **dadurch gekennzeichnet, dass** wenigstens ein elektrischer Anschluss des Elektromotors (2) das Wärmeleitelement (14) durchgreift.

6. Elektrische Antriebseinrichtung nach einem der vorhergehenden Ansprüche, **dadurch gekennzeichnet, dass** die Gegenanschlussfläche (13) an einem Motorflansch (15) des Motorgehäuses (3) vorliegt.

7. Elektrische Antriebseinrichtung nach einem der vorhergehenden Ansprüche, **dadurch gekennzeichnet, dass** der Kühlmittelkanal (6) durch den Motorflansch (15) verläuft.

8. Elektrische Antriebseinrichtung nach einem der vorhergehenden Ansprüche, **dadurch gekennzeichnet, dass** der Kühlmittelkanal (6) einen Abstand von der Gegenanschlussfläche (13) aufweist, die bezogen auf einen Durchmesser des Kühlmittelkanals (6) kleiner ist als 1, als 0,75, als 0,5 oder als 0,25.

9. Elektrische Antriebseinrichtung nach einem der vorhergehenden Ansprüche, **dadurch gekennzeichnet, dass** der Kühlmittelkanal (6) einen Rotor des Elektromotors (2) in Umfangsrichtung bezüglich einer Drehachse (5) des Rotors wenigstens bereichsweise, insbesondere vollständig, umgreift.

10. Elektrische Antriebseinrichtung nach einem der vorhergehenden Ansprüche, **dadurch gekennzeichnet, dass** die Anschlussfläche (12) einer Seitenfläche des Elektronikgehäuses (11) entspricht.
